(19) Europäisches Patentamt / European Patent Office / Office européen des brevets

(11) **EP 2 795 349 B1**

(12) **FASCICULE DE BREVET EUROPEEN**

(45) Date de publication et mention de la délivrance du brevet:
**06.02.2019 Bulletin 2019/06**

(51) Int Cl.:
***G01R 19/25*** (2006.01)     ***G01R 22/06*** (2006.01)
***G01R 21/133*** (2006.01)

(21) Numéro de dépôt: **12810368.6**

(22) Date de dépôt: **07.12.2012**

(86) Numéro de dépôt international:
**PCT/FR2012/052830**

(87) Numéro de publication internationale:
**WO 2013/093281 (27.06.2013 Gazette 2013/26)**

(54) **PROCEDE DE DETERMINATION D'UNE CONSOMMATION DE PUISSANCE, SYSTEME DE SUPERVISION ET INSTALLATION ELECTRIQUE EN COMPORTANT APPLICATION**

VERFAHREN ZUR BESTIMMUNG EINES STROMVERBRAUCHS, ÜBERWACHUNGSSYSTEM UND EINE, EIN SOLCHES ENTHALTENDE, ELEKTRISCHE ANLAGE

METHOD FOR DETERMINING A POWER CONSUMPTION, MONITORING SYSTEM AND ELECTRICAL INSTALLATION COMPRISING THE APPLICATION THEREOF

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.12.2011 FR 1103957**

(43) Date de publication de la demande:
**29.10.2014 Bulletin 2014/44**

(73) Titulaire: **Schneider Electric Industries SAS 92500 Rueil-Malmaison (FR)**

(72) Inventeur: **BRUEL, Marc 38050 Cedex 09 Grenoble (FR)**

(74) Mandataire: **Tripodi, Paul**
**Schneider Electric Industries SAS**
**Service Propriété Industrielle**
**World Trade Center / 38EE1**
**5 Place Robert Schuman**
**38050 Grenoble Cedex 09 (FR)**

(56) Documents cités:
**EP-A1- 2 026 299**     **EP-A1- 2 241 898**
**EP-A2- 0 853 364**     **WO-A1-2009/158202**
**WO-A1-2011/002735**     **US-A- 5 696 695**
**US-A1- 2007 185 665**     **US-A1- 2008 140 326**
**US-A1- 2009 088 990**

- **CHUNG-PING YOUNG ET AL: "Digital Power Metering Manifold", IEEE TRANSACTIONS ON INSTRUMENTATION AND MEASUREMENT, IEEE SERVICE CENTER, PISCATAWAY, NJ, US, vol. 47, no. 1, 1 février 1998 (1998-02-01), XP011024460, ISSN: 0018-9456**

**Description**

**Domaine technique de l'invention**

L'invention concerne un procédé de détermination d'une consommation de puissance, dans une installation électrique comprenant un groupe de plusieurs branches de distribution individuelle d'électricité entre plusieurs charges, ainsi qu'une ligne principale amont raccordant le groupe de branches à une alimentation électrique. Le procédé en question est d'un type selon lequel il comprend l'action d'effectuer dans le temps et d'enregistrer des mesures prises au niveau de la ligne principale amont et permettant d'établir la puissance globale consommée par le groupe de branches.

L'invention concerne également un système de supervision d'un groupe de plusieurs branches de distribution individuelle d'électricité entre plusieurs charges dans une installation électrique, du type comportant au moins :

- un dispositif de réalisation de mesures au niveau d'une ligne principale amont raccordant le groupe de branches à une alimentation électrique,
- une mémoire d'enregistrement de ces mesures qui permettent d'établir la puissance globale consommée par le groupe de branches,
- un transducteur d'équipement d'une branche particulière parmi les branches.

L'invention concerne encore une installation électrique, du type comportant un groupe de plusieurs branches de distribution individuelle d'électricité entre plusieurs charges, une ligne principale amont raccordant le groupe de branches à une alimentation électrique.

**État de la technique**

Les particuliers comme les autres agents économiques montrent un intérêt croissant pour la maîtrise de leurs propres consommations électriques. Un axe de cette maîtrise repose sur une connaissance détaillée de différentes consommations particulières à l'intérieur d'une consommation globale. Par exemple, les habitants d'une maison ou d'un logement d'un autre type peuvent s'intéresser à leur consommation électrique due au chauffage, à celle consacrée à l'éclairage et/ou celle due à tel équipement, sans se satisfaire de la seule connaissance de la consommation globale à l'échelle du logement.

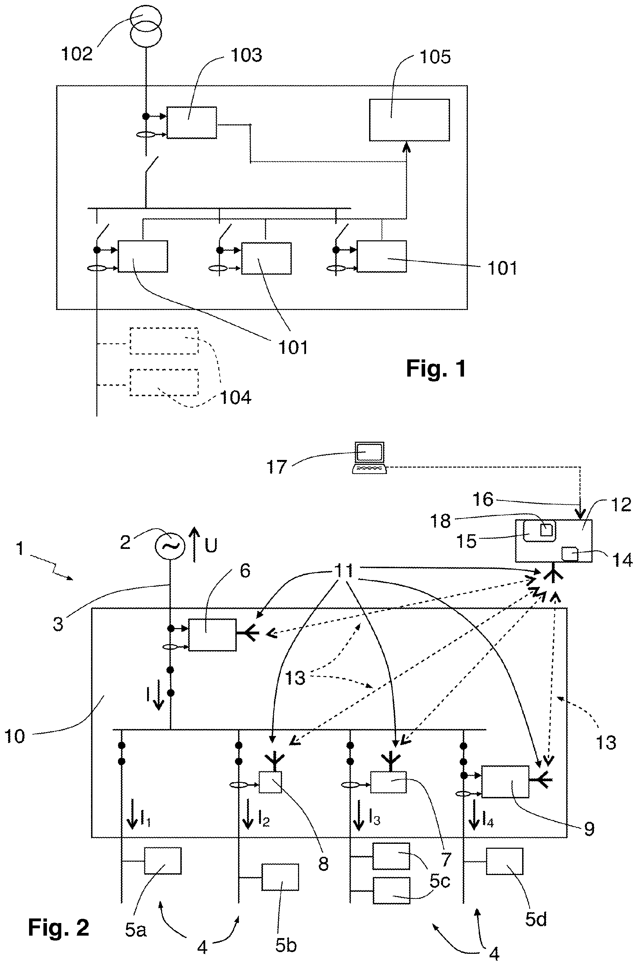

A l'heure actuelle, les habitants d'un logement peuvent généralement avoir accès à leur consommation électrique globale, grâce à un compteur de consommation électrique équipant la ligne de raccordement au réseau public de distribution qui alimente le logement. Lorsque l'on souhaite connaître une consommation individuelle par exemple d'un équipement au sein du logement, on équipe d'un compteur de consommation électrique la branche dans laquelle est connecté cet équipement. La figure 1 annexée est un schéma représentant un exemple actuel d'installation électrique domestique, dans lequel plusieurs compteurs de consommation électrique 101 renseignent sur plusieurs consommations individuelles constitutives d'une consommation électrique globale.

Sur cette figure 1, la référence 102 désigne un transformateur de raccordement à réseau public de distribution d'énergie électrique. Une arrivée amont équipée d'un compteur de consommation électrique 103 raccorde l'installation électrique à ce transformateur 102. Identique ou semblable au compteur 103, chaque compteur de consommation électrique 101 équipe un départ parmi plusieurs départs de distribution d'énergie électrique à plusieurs charges 104. Un réseau filaire est prévu pour acheminer les différents comptages à une centrale électronique de mesure 105, qui rassemble ces comptages.

Un compteur de consommation électrique est à la fois coûteux et encombrant. Lorsque l'on souhaite pouvoir suivre plusieurs consommations individuelles à l'intérieur d'une installation, le surcoût résultant de la multiplication des compteurs de consommation électrique devient conséquent et peut constituer un véritable frein à une véritable mise en place d'un système de suivi de consommations individuelles. La possibilité d'une telle multiplication de compteurs peut en outre se heurter au manque d'espace disponible dans nombre de tableaux généraux électriques actuellement en service chez les particuliers.

Par ailleurs, des recherches se sont portées sur l'identification d'un type de charge au sein d'une installation, au moyen d'une analyse mathématique de spécificités dans le courant d'alimentation de cette installation. Les brevets et/ou demandes de brevet US-2010/0287489, JP2003/070186, WO2010/037988, WO2001/177696, EP-2 000 780, EP-2 026 299, WO1010/014762 témoignent de ces recherches. Les solutions qui y sont proposées sont lourdes en termes de moyens logiciels et sont onéreuses, sans réellement permettre à un souscripteur d'accéder aux consommations individuelles des équipements de son installation électrique.

Les documents WO-2011/002735 A, US-5,696,695 A et WO-2009/158202 A décrivent aussi des systèmes de supervision d'un groupe de plusieurs branches des distribution individuelle d'électricité entre plusieurs charges dans une installation électrique.

**Objet de l'invention**

L'invention a au moins pour but de permettre une réduction du coût d'accès à la connaissance d'une consommation électrique individuelle constitutive d'une consommation électrique globale mesurée, au sein d'une installation électrique en courant alternatif.

Selon l'invention, ce but est atteint grâce à un procédé et un système définis dans les revendications.

Certaines charges consomment toujours la même puissance lorsqu'elles ne sont pas à l'arrêt. Dans d'autres sortes de charges, la puissance consommée peut varier entre plusieurs valeurs différentes, mais elle varie toujours par paliers.

On a constaté que, à condition de s'intéresser à la nature des charges dans une installation électrique, on peut faire en sorte que la consommation énergétique individuelle d'une charge connectée dans l'une de plusieurs branches puisse être déduite alors qu'on ne dispose pas de mesures pour l'ensemble des grandeurs électriques caractérisant le fonctionnement de cette charge. Dans certains cas en particulier, la consommation énergétique d'une charge connectée dans l'une de plusieurs branches peut être déduite moyennant une surveillance des changements affectant cette consommation. Elle peut l'être à partir de mesures des valeurs caractérisant l'alimentation électrique globale de l'ensemble des branches avant et après de tels changements, et éventuellement à partir d'autres mesures.

Or, la disponibilité d'une mesure des grandeurs caractérisant l'alimentation électrique globale d'un ensemble de plusieurs branches est un cas courant en distribution électrique. Ce cas est notamment celui des installations électriques dans lesquelles plusieurs départs sont connectés à une même arrivée de raccordement à un réseau public de distribution d'énergie électrique et dans lesquelles cette arrivée est équipée d'un compteur de consommation d'énergie électrique. Dans un tel cas, l'invention peut permettre de simplifier l'instrumentation équipant la branche particulière dont on veut suivre la consommation. En particulier, cette instrumentation peut se réduire à un détecteur de courant lorsqu'il s'agit seulement de surveiller les changements affectant la consommation dans la branche. Un détecteur de courant est généralement bien moins coûteux et moins encombrant qu'un compteur de consommation d'énergie électrique. Il en est de même d'un capteur de courant ou ampèremètre.

Le procédé de détermination d'une consommation électrique peut incorporer une ou plusieurs autres caractéristiques avantageuses, isolément ou en combinaison, en particulier parmi celles définies ci-après.

Avantageusement, l'étape d) comporte des sous-étapes dans lesquelles :

d1) en combinant ladite indication et une table établissant au moins une correspondance entre au moins la branche particulière et au moins une manière d'un jeu de plusieurs manières de déterminer une consommation individuelle d'énergie dans une branche, on sélectionne une manière dans le jeu de manières de déterminer une consommation individuelle,
d2) en utilisant la manière sélectionnée, on détermine la consommation individuelle particulière d'énergie.

Les branches de distribution individuelle peuvent être connectées en parallèle. De préférence, dans le cas où l'alimentation électrique est en courant alternatif, une manière spécifique du jeu comprend l'action d'effectuer dans le temps et d'enregistrer des mesures d'une tension globale d'alimentation du groupe de plusieurs branches, des mesures des valeurs d'intensité et de déphasage d'un courant global d'alimentation du groupe de plusieurs branches, ainsi que des mesures de l'intensité d'un courant individuel spécifique circulant dans une branche spécifique du groupe de branches. De préférence, la manière spécifique comporte une étape dans laquelle :

e) en utilisant une mesure de la tension globale sensiblement constante pendant le changement, des mesures des valeurs d'intensité et de déphasage du courant global avant et après le changement, ainsi que des mesures des intensités du courant individuel spécifique avant et après le changement, on détermine une puissance individuelle consommée dans la branche spécifique.

Avantageusement, dans l'étape e), on détermine la puissance individuelle en considérant que l'ensemble des courants individuels circulant dans les branches du groupe à l'exception du courant individuel spécifique s'additionnent en une somme sensiblement inchangée à l'issue du changement, par rapport à avant le changement, et que doivent être simultanément satisfaites deux conditions qui sont :

- que le courant global avant le changement doit être sensiblement égal à l'ajout de la somme sensiblement inchangée au courant individuel spécifique avant le changement, et
- que le courant global après le changement doit être sensiblement égal à l'ajout de la somme sensiblement inchangée au courant individuel spécifique après le changement.

Avantageusement dans l'étape e), on élimine une solution aberrante parmi deux solutions possibles.

Les branches de distribution individuelle peuvent être connectées en parallèle. De préférence, lorsque l'alimentation électrique est en courant continu, une manière spécifique du jeu comprend l'action d'effectuer des mesures d'une tension globale d'alimentation du groupe de plusieurs branches, ainsi que des mesures de l'intensité d'un courant individuel spécifique circulant dans une branche spécifique du groupe de branches, la manière spécifique comportant une étape dans laquelle :

e) en utilisant une mesure de la tension globale et une mesure de l'intensité du courant individuel spécifique, on détermine une puissance individuelle consommée dans la branche spécifique.

Avantageusement, l'étape e) comporte des sous-étapes dans lesquelles :

e1) en utilisant des mesures des valeurs d'intensité et de déphasage du courant global avant et après le changement, ainsi que des mesures des intensités du courant individuel particulier avant et après le changement, on détermine ladite somme sensiblement inchangée de courants individuels comme satisfaisant simultanément auxdites deux conditions,
e2) on détermine quelle composante doit être ajoutée à la somme sensiblement inchangée de courants individuels pour obtenir le courant global, cette composante étant une détermination du courant individuel particulier,
e3) on calcule la puissance individuelle particulière comme étant le produit de la tension globale et du courant individuel particulier.

Avantageusement, dans la sous-étape e1), on détermine ladite somme sensiblement inchangée de courants individuels en résolvant numériquement un système de deux équations à deux inconnues, qui est le suivant :

$$\begin{cases} (X_A - X_S)^2 + (Y_A - Y_S)^2 = I_{3A}^2 \\ (X_B - X_S)^2 + (Y_B - Y_S)^2 = I_{3B}^2 \end{cases}$$

où $I_{3A}^2$ et $I_{3B}^2$ sont respectivement une mesure au carré de l'intensité du courant individuel spécifique avant le changement et une mesure au carré de l'intensité du courant individuel spécifique après le changement,
où $X_A$ et $Y_A$ sont respectivement l'abscisse et l'ordonnée de la représentation vectorielle du courant global tel que mesuré avant le changement, dans un diagramme de Fresnel,
où $X_B$ et $Y_B$ sont respectivement l'abscisse et l'ordonnée de la représentation vectorielle du courant global tel que mesuré après le changement, dans le diagramme de Fresnel,
et où $X_S$ et $Y_S$ sont deux inconnues et sont respectivement l'abscisse et l'ordonnée de la représentation vectorielle de ladite somme sensiblement inchangée de courants individuels, dans le diagramme de Fresnel, avant et après le changement.

Avantageusement, l'étape e) comprend des sous-étapes dans lesquelles :

- on détermine une valeur d'intensité AB au moyen de la relation suivante :

$$AB = \sqrt{I_A^2 + I_B^2 - 2 \times I_A \times I_B \times \cos(\psi_B - \psi_A)}$$

où $I_A$ et $\psi_A$ sont respectivement une intensité et un déphasage mesurés du courant global (I) avant le changement et où $I_B$ et $\psi_B$ sont respectivement une intensité et un déphasage mesurés du courant global après le changement,
- on détermine une valeur d'angle $\psi_1$ au moyen de la relation suivante :

$$\psi_1 = \arcsin\left(\frac{I_B \times \cos \psi_B - I_A \times \cos \psi_A}{AB}\right),$$

- on détermine une valeur d'angle $\psi_2$ au moyen de la relation suivante :

$$\psi_2 = \arccos\left(\frac{I_{3B}^2 + AB^2 - I_{3A}^2}{2 \times I_{3B} \times AB}\right)$$

où $I_{3A}$ et $I_{3B}$ sont respectivement une mesure de l'intensité du courant individuel spécifique avant le changement et une mesure de l'intensité du courant individuel spécifique après le changement.

Avantageusement, l'étape e) comprend une sous-étape dans laquelle :

- on détermine la puissance individuelle particulière après le changement au moyen de la relation suivante :

$$P_{3B} = U \times I_{3B} \times \sin\left(\psi_1 + \psi_2\right)$$

où $P_{3B}$ et $U$ sont respectivement ladite puissance individuelle particulière après le changement et la mesure de la tension globale.

Avantageusement, le procédé de détermination d'une consommation de puissance comprend une étape dans laquelle :

- on détermine le déphasage du courant individuel particulier après le changement, au moyen de la relation suivante :

$$\psi_{3B} = \pi/2 - \left(\psi_1 + \psi_2\right)$$

où $\psi_{3B}$ est le déphasage du courant individuel particulier après le changement.

Avantageusement, dans l'une des manières de déterminer une consommation individuelle d'énergie, on détermine une puissance individuelle consommée dans l'une des branches comme étant égale à la différence entre une puissance globale consommée dans le groupe de branches avant le changement et une puissance globale consommée dans le groupe de branches après ce changement.
Avantageusement, dans l'une des manières de déterminer une consommation individuelle d'énergie, on mesure une puissance individuelle consommée dans une branche du groupe de branches.
L'invention a également pour objet un système de supervision qui est du type précité et qui comporte un dispositif calculateur à même :

- de détecter un changement quant à la consommation électrique dans l'installation, en communiquant avec l'un au moins des dispositifs que sont le dispositif de réalisation de mesure et le transducteur, et
- de surveiller une information relative à un courant électrique dans la branche particulière, en provenance du transducteur équipant cette branche particulière, puis
- au moyen de l'information en provenance du transducteur équipant la branche particulière, d'établir une indication selon laquelle ledit changement s'est produit au niveau de cette branche particulière, puis
- en utilisant à la fois des données parmi les mesures prises au niveau de la ligne principale amont avant le changement et des données parmi les mesures prises au niveau de la ligne principale amont après le changement, ainsi que ladite indication, de déterminer une consommation individuelle particulière d'énergie dans ladite branche particulière.

Le système de supervision selon l'invention peut incorporer une ou plusieurs autres caractéristiques avantageuses, isolément ou en combinaison, en particulier parmi celles définies ci-après.
Avantageusement, le dispositif calculateur possède plusieurs manières de déterminer une consommation individuelle d'énergie dans une branche et une table pour établir au moins une correspondance entre l'une au moins des branches et l'une au moins des manières. De préférence, le dispositif calculateur est à même de sélectionner une manière spécifique parmi les manières de déterminer une consommation individuelle, en combinant ladite indication et la table, et de déterminer la consommation individuelle particulière d'énergie en utilisant la manière spécifique sélectionnée.
Avantageusement, pour une installation électrique en courant alternatif, le système de supervision est adapté pour effectuer dans le temps et enregistrer des mesures d'une tension globale d'alimentation du groupe de plusieurs branches, des mesures des valeurs d'intensité et de déphasage d'un courant global d'alimentation du groupe de plusieurs branches, ainsi que des mesures de l'intensité d'un courant individuel spécifique circulant dans une branche spécifique du groupe de branches. De préférence, le dispositif calculateur comprend un moyen de détermination d'une puissance individuelle consommée dans la branche spécifique, en utilisant une mesure de la tension globale sensiblement constante pendant le changement, des mesures des valeurs d'intensité et de déphasage du courant global avant et après le changement, ainsi que des mesures des intensités du courant individuel spécifique avant et après le changement.

Avantageusement, le moyen de détermination d'une puissance individuelle est adapté pour déterminer cette puissance individuelle en considérant que l'ensemble des courants individuels circulant dans les branches du groupe à l'exception du courant individuel spécifique s'additionnent en une somme sensiblement inchangée à l'issue du changement, par rapport à avant le changement, et que doivent être simultanément satisfaites deux conditions qui sont :

- que le courant global avant le changement doit être sensiblement égal à l'ajout de la somme sensiblement inchangée au courant individuel spécifique avant le changement, et
- que le courant global après le changement doit être sensiblement égal à l'ajout de la somme sensiblement inchangée au courant individuel spécifique après le changement.

Avantageusement, le dispositif calculateur comprend un moyen d'élimination d'une solution aberrante parmi deux solutions possibles.

Avantageusement, pour une installation électrique en courant continu, le système de supervision est adapté pour effectuer des mesures d'une tension globale d'alimentation du groupe de plusieurs branches, ainsi que des mesures de l'intensité d'un courant individuel spécifique circulant dans une branche spécifique du groupe de branches. De préférence, le dispositif calculateur comprend un moyen de détermination d'une puissance individuelle consommée dans la branche spécifique, en utilisant une mesure de la tension globale et une mesure de l'intensité du courant individuel spécifique.

Avantageusement, le dispositif calculateur comprend un moyen de détermination d'une puissance individuelle consommée dans l'une des branches comme étant égale à la différence entre une puissance globale consommée dans le groupe de branches avant le changement et une puissance globale consommée dans le groupe de branches après ce changement.

Avantageusement, le dispositif calculateur est à même de conduire un procédé tel que défini précédemment.

L'invention a encore pour objet une installation électrique qui est du type précité et qui comporte un système de supervision tel que défini précédemment. Le dispositif de réalisation de mesures équipe la ligne principale amont. Une branche particulière parmi les branches est équipée du transducteur.

## Description sommaire des dessins

Parmi les figures annexées, la figure 1 est un schéma électrique simplifié d'une installation électrique selon un art antérieur à l'invention.

D'autres avantages et caractéristiques ressortiront plus clairement de la description qui va suivre de modes particuliers de réalisation de l'invention donnés à titre d'exemples non limitatifs et représentés aux dessins annexés, parmi lesquels :

- la figure 2 est un schéma électrique simplifié d'une installation électrique conforme à l'invention ;
- la figure 3 est un organigramme de la logique de fonctionnement d'un procédé qui est conforme à l'invention et qui est mis en oeuvre dans le cadre d'un suivi de consommations individuelles constitutives de la consommation globale de l'installation électrique de la figure 2 ;
- la figure 4 est un diagramme de Fresnel illustrant comment procède une manière de déterminer l'une des consommations individuelles précitées, dans le procédé conforme à l'invention ;
- la figure 5 est un diagramme de Fresnel qui reprend celui de la figure 4 et qui indique en outre des détails complémentaires concernant une opération incluse dans la manière illustrée à cette figure 4 ;
- la figure 6 est un diagramme de Fresnel qui reprend également celui de la figure 4 et qui indique en outre des détails complémentaires concernant une façon possible de mettre en oeuvre la manière schématisée à cette figure 4.

## Description d'un mode préférentiel de l'invention

Sur la figure 2 est représentée une installation électrique 1 adaptée pour une mise en oeuvre d'un procédé conforme à l'invention. Dans un souci de clarté, la figure 2 est simplifiée et certains constituants classiques y sont omis. En particulier, la phase seule est représentée, alors que le neutre ne l'est pas.

L'installation électrique 1 peut appartenir à un consommateur final et se trouver dans un ensemble ou un bâtiment, tel qu'un bâtiment d'habitation ou un immeuble de bureaux, où il existe plusieurs charges distinctes à alimenter et où il y a lieu d'effectuer une distribution d'énergie électrique. Cette installation électrique 1 peut notamment être celle d'une maison individuelle ou celle d'un logement de particuliers.

L'installation électrique 1 est alimentée par une alimentation électrique en courant alternatif sinusoïdal 2, à laquelle elle est raccordée par une ligne principale amont ou arrivée 3 et qui peut notamment être un réseau public de distribution d'énergie électrique.

Plusieurs départs sont connectés à l'arrivée 3. Chacun d'eux fait partie de l'une de plusieurs branches 4 montées en parallèle, dans lesquelles sont connectées des charges 5a, 5b, 5c et 5d à alimenter. Dans l'exemple représenté, ces branches 4 sont au nombre de quatre. Il va de soi que leur nombre peut être différent de quatre.

L'arrivée 3 est équipée d'un compteur de consommation d'énergie électrique 6, qui mesure dans le temps plusieurs grandeurs caractéristiques de la fourniture électrique globale au groupe de branches 4, à savoir la tension globale d'alimentation U, ainsi que les valeurs d'intensité et de déphasage du courant global d'alimentation I circulant dans l'arrivée 3. Un dispositif de réalisation des mêmes mesures que le compteur 6 peut être utilisé à la place de ce dernier, sans être à proprement parler un compteur de consommation d'énergie électrique.

Une ou plusieurs branches 4 peuvent être équipées chacune d'un capteur de courant ou ampèremètre 7. Dans l'exemple représenté, un ampèremètre 7 mesure l'intensité du courant individuel $I_3$ dans une branche 4.

Une ou plusieurs branches 4 peuvent être équipées chacune d'un détecteur de courant 8. Dans l'exemple représenté, un détecteur de courant 8 détecte la présence ou l'absence d'un courant individuel $I_2$ dans une branche 4.

Une ou plusieurs branches 4 peuvent être équipées chacune d'un compteur de consommation d'énergie électrique 9, qui peut être identique au compteur 6. Dans l'exemple représenté, un compteur de consommation 9 mesure dans le temps la puissance consommée dans la branche 4 où circule le courant $I_4$. Il peut également mesurer plusieurs grandeurs caractéristiques de l'alimentation électrique de cette branche 4 et permettant de déterminer la puissance qui y est consommée.

Chacun des appareils que sont l'ampèremètre 7, le capteur de courant 8 et le compteur de consommation 9 possède au moins un transducteur transformant une grandeur électrique en un signal électrique représentant une mesure ou une autre information.

Une ou plusieurs branches 4 peuvent être dépourvues d'un tel transducteur, ce qui peut résulter de ce qu'on ne s'intéresse pas à leur consommation d'énergie ou de ce qu'on est dans un cas où cette consommation peut être déduite sans information en provenance de la branche 4 concernée. Dans l'exemple représenté, aucun appareillage de mesure ou de détection n'équipe la branche 4 dans laquelle circule le courant $I_1$.

La référence 10 désigne un tableau général basse tension où sont regroupés plusieurs appareils électriques, y compris les compteurs de consommation 6 et 9, ainsi que l'ampèremètre 7 et le détecteur de courant 8.

Un système de communication 11 permet à une centrale électronique de mesure 12 de communiquer avec l'instrumentation de mesure et de détection, à savoir les compteurs de consommation 6 et 9, l'ampèremètre 7 et le détecteur de courant 8. La centrale de mesure 12 recueille et enregistre dans le temps, c'est-à-dire tout du long du fonctionnement de l'installation électrique 1, des données en provenance de l'instrumentation de mesure et de détection. De préférence, les transferts de données 13 se font au moyen d'une communication sans fil, telle qu'une communication hertzienne, ce qui est le cas dans l'exemple représenté. Toutefois, la communication 13 entre l'instrumentation de mesure et la centrale 12 peut également être filaire voire mixte.

Les données recueillies par la centrale 12 sont enregistrées par une mémoire 14 de cette centrale 12, qui comprend également un dispositif calculateur 15 pour les traiter.

Les compteurs de consommation 6 et 9, l'ampèremètre 7, le détecteur de courant 8, le système de communication 11 et la centrale de mesure 12 forment ensemble tout ou partie d'un système qui est conforme à l'invention et qui est plus précisément un système de supervision du fonctionnement de l'installation électrique 1.

La centrale 12 est équipée d'au moins un port d'entrée/sortie 16, au moyen duquel elle peut communiquer avec un dispositif extérieur tel qu'un ordinateur de supervision, de contrôle et/ou de pilotage. Sur la figure 2, ce dispositif extérieur est un ordinateur de configuration 17, au moyen duquel un opérateur a renseigné une table 18 du dispositif calculateur 15 notamment en fonction des types des charges 5a, 5b, 5c et 5d dans les branches 4 et en fonction de la manière dont ces branches 4 sont instrumentées en conséquence.

La charge 5a connectée dans la branche 4 où circule le courant $I_1$ possède une impédance constante. Elle consomme une puissance active et/ou une puissance réactive dont chacune est soit nulle, à l'arrêt, soit égale à une valeur sensiblement fixe. Cette valeur est en outre unique dans l'installation électrique 1, ce qui est consigné dans la table 18 au moyen d'un classement de la branche 4 parcourue par le courant $I_1$ dans une première catégorie. Si une variation de la puissance globale consommée par cette installation 1 est égale à la valeur unique précitée, on sait que cette variation de puissance doit être affectée à la branche 4 parcourue par le courant $I_1$.

La charge 5b connectée dans la branche 4 où circule le courant $I_2$ possède une impédance constante. Elle consomme une puissance active et/ou une puissance réactive dont chacune soit nulle, à l'arrêt, soit égale à une valeur sensiblement fixe, ce qui est consigné dans la table 18 au moyen d'un classement de la branche parcourue par le courant $I_2$ dans une deuxième catégorie.

Dans la branche 4 où circule le courant $I_3$, les changements de consommation de puissance se font par palier, du fait de la nature de ses charges 5c. En d'autres termes, la puissance consommée dans cette branche 4 est sensiblement stable entre deux changements, ce qui est consigné dans la table 18 au moyen d'un classement de la branche parcourue par le courant $I_3$ dans une troisième catégorie.

Dans la branche 4 où circule le courant $I_4$, la puissance active et/ou la puissance réactive consommées peuvent varier progressivement sur de longs intervalles de temps, ce qui est consigné dans la table 18 au moyen d'un classement de la branche parcourue par le courant $I_4$ dans une quatrième catégorie.

La table 18 est renseignée lors d'une étape de configuration qui peut être menée par un opérateur et/ou par le dispositif calculateur 15 et dans laquelle on mène des investigations pour pouvoir classer chacune des branches 4 observées dans l'une des première, deuxième, troisième et quatrième catégories précitées.

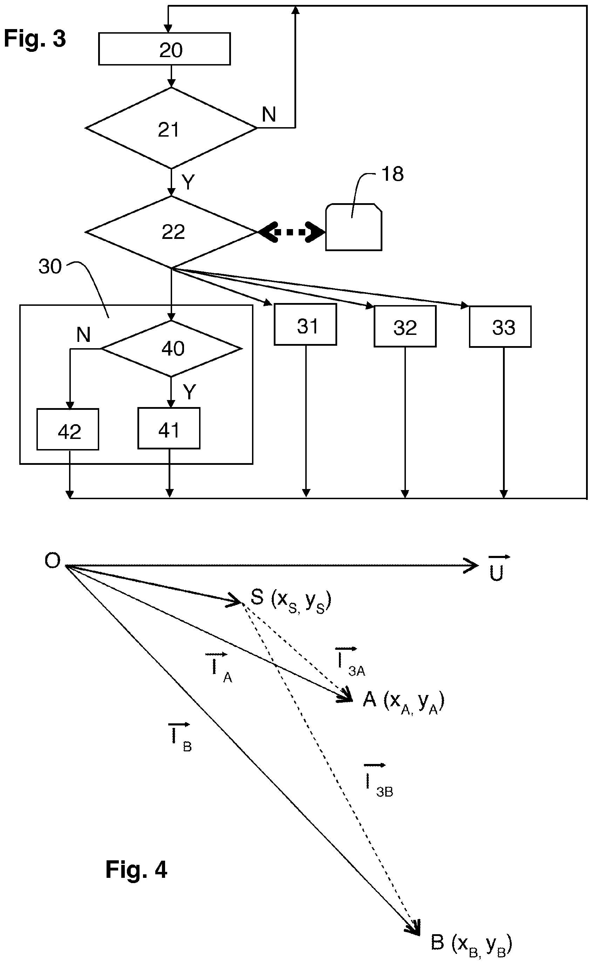

Le dispositif calculateur 15 conduit le procédé dont la logique est représentée à la figure 3. A une première étape 20 de ce procédé, le dispositif calculateur 15 surveille les apparitions de changements affectant les intensités des courants dans les branches 4 et/ou la consommation globale de l'installation électrique 1. Lorsqu'un tel changement a été détecté, le dispositif calculateur 15 passe à une étape 21, dans laquelle il réalise un filtrage distinguant les changements significatifs et durables des autres changements, insignifiants et/ou passagers.

Les changements significatifs sont définis comme supérieurs à un seuil prédéterminé qui est choisi en tenant compte de diverses données comme le type d'emploi de l'installation électrique 1. Les changements passagers sont définis comme ayant une durée supérieure à une temporisation prédéterminée, par exemple de l'ordre de 2 à 3 s. Dans le cas où il est répondu par la négative à la question de savoir si le changement détecté est significatif et durable, le dispositif calculateur 15 revient à l'étape de surveillance 20. Dans le cas contraire, une étape 22 est entamée.

Dans cette étape 22, le dispositif calculateur 15 détermine dans quelle branche 4 a eu lieu le changement de consommation de puissance. Lorsque le changement est intervenu dans la branche parcourue par le courant $I_1$, le dispositif calculateur déduit cela de ce que la variation de la consommation globale de puissance par l'installation 1 est sensiblement égale à la puissance que seule la charge 5a consomme lorsqu'elle est active. Dans les autres cas, le dispositif calculateur 15 détermine l'origine du changement de consommation à partir des informations en provenance du détecteur de courant 8, de l'ampèremètre 7 et du compteur 9.

Le dispositif calculateur 15 dispose de plusieurs manières 30, 31, 32 et 33 de déterminer une puissance individuelle consommée dans une branche 4. Chacune de ces manières de procéder 30 à 33 est adaptée à un cas parmi ceux correspondant aux première, deuxième, troisième et quatrième catégories précitées.

Lorsqu'il sait dans quelle branche 4 la puissance consommée a changé, le dispositif calculateur 15 sélectionne la manière de procéder 30, 31, 32 ou 33 qui sera employée pour déterminer la puissance consommée dans cette branche 4. Pour ce faire, toujours à l'étape 22, le dispositif calculateur 15 consulte la table 18 qui est une table de correspondance et où, à chaque branche 4 observée, est attribuée l'une des quatre catégories précitées, c'est-à-dire l'une des manières de procéder 30 à 33. A l'issue de l'étape 22, le dispositif calculateur 15 procède selon la manière de procéder 30, 31, 32 ou 33 qu'il vient de retenir.

La manière 30 de déterminer une puissance individuelle convient pour les branches 4 dans lesquelles les changements de consommation de puissance se font par palier, du fait de la nature de leurs charges. En d'autres termes, elle convient lorsque la puissance consommée dans une branche 4 est sensiblement stable entre deux changements.

La manière 30 de déterminer une puissance individuelle va maintenant être décrite dans le cas d'un changement de consommation dans la branche 4 où circule le courant $I_3$. A une étape 40 de cette manière 30, le dispositif calculateur 15 répond à la question de savoir si le courant individuel $I_3$ était nul ou non avant le changement.

Dans l'affirmative, un calcul simplifié est mené à l'étape 41 et consiste à déterminer la puissance individuelle consommée dans les charges 5c après le changement comme étant égale à la variation de la puissance globale consommée par l'installation électrique et déterminé par le compteur de consommation 6 ou à partir de ses seules mesures des grandeurs caractéristiques de l'alimentation électrique globale du groupe de branches 4, c'est-à-dire des valeurs de tension, d'intensité et de déphasage de cette alimentation.

Si le courant individuel $I_3$ n'était pas nul avant le changement, le dispositif calculateur 15 exécute l'étape 42, dans laquelle il détermine la nouvelle puissance individuelle consommée dans la branche 4 parcourue par ce courant $I_3$ et dans laquelle il procède d'une façon explicitée ci-dessous à l'aide du diagramme de Fresnel de la figure 4.

Cette façon de procéder considère que l'installation électrique 1 est alimentée par un courant sensiblement sinusoïdal, avec pas ou peu de distorsions harmoniques. En cas de distorsions harmoniques, la puissance individuelle déterminée par le dispositif calculateur 15 sera moins précise.

Au moins dans les formules de calcul de puissance présentes dans ce qui suit et/ou dans les revendications annexées, les valeurs de tension et d'intensité mentionnées sont des valeurs efficaces.

Représentée par le vecteur $\vec{U}$ à la figure 4, la tension aux bornes de chaque branche 4 est la tension globale U d'alimentation de l'installation 1. Le changement de consommation de puissance n'a qu'un effet très faible sinon insignifiant sur elle. De ce fait, on considère que cette tension globale U n'est pas modifiée lors du changement de

EP 2 795 349 B1

consommation de puissance. En revanche, ce changement affecte le courant global I comme le courant individuel $I_3$.

Sur la figure 4, le vecteur $\vec{I}_A$ et le vecteur $\vec{I}_{3A}$ sont respectivement la représentation graphique du courant global I et la représentation graphique du courant individuel $I_3$ à un même instant, qui est un premier instant se situant avant le changement. Le vecteur $\vec{I}_B$ et le vecteur $\vec{I}_{3B}$ sont respectivement la représentation graphique du courant global I et la représentation graphique du courant individuel $I_3$ à un autre même instant, qui est un deuxième instant se situant après le changement. Le premier comme le deuxième instant sont choisis hors de la phase de changement proprement dite. En d'autres termes, chacun d'eux se trouve dans une phase de fonctionnement stabilisé et constant de l'installation électrique 1, de manière que les transitoires en soient exclus.

Les valeurs de tension, d'intensité et de déphasage mesurées par le compteur 6 déterminent les vecteurs $\vec{U}$, $\vec{I}_A$ et $\vec{I}_B$, qui sont donc connus. En revanche, les grandeurs caractérisant le courant individuel $I_3$ ne sont pas toutes mesurées. En effet, seules les intensités le sont, à l'exception des déphasages, en ce qui concerne ce courant individuel $I_3$.

Une variation de puissance ne s'est produite que dans la branche 4 où circule le courant $I_3$. L'ensemble des courants individuels circulant dans les autres branches 4, à l'exception donc du courant individuel $I_3$, s'additionnent en une somme sensiblement inchangée entre le premier instant avant le changement de consommation de puissance et le deuxième instant après ce changement. Dans l'exemple considéré, cette somme est la somme des courants $I_1$ et $I_2$. Sa représentation graphique à la figure 4 est le vecteur $\overrightarrow{OS}$, où O est l'origine d'un repère orthonormé.

Comme ce vecteur $\overrightarrow{OS}$ est le même avant et après le changement, il doit être satisfait à la fois :

- que $\overrightarrow{OS} + \vec{I}_{3A} = \vec{I}_A (= \overrightarrow{OA})$, et
- que $\overrightarrow{OS} + \vec{I}_{3B} = \vec{I}_B (= \overrightarrow{OB})$.

C'est ce qu'illustre la figure 4.

La norme du vecteur $\vec{I}_{3A}$ est la mesure $I_{3A}$ de l'intensité du courant $I_3$ avant le changement. La norme du vecteur $\vec{I}_{3B}$ est la mesure $I_{3B}$ de l'intensité du courant $I_3$ après le changement. Le point S est à l'intersection de deux cercles, à savoir un cercle de centre A et de rayon l'intensité $I_{3A}$ du courant $I_3$ telle que mesurée avant le changement et un cercle de centre B et de rayon l'intensité $I_{3B}$ du courant $I_3$ telle que mesurée après le changement.

Sur la base de ce qui précède, une première façon de procéder est de résoudre numériquement un système de deux équations à deux inconnues, qui est le suivant :

$$\begin{cases} (X_A - X_S)^2 + (Y_A - Y_S)^2 = I_{3A}^2 \\ (X_B - X_S)^2 + (Y_B - Y_S)^2 = I_{3B}^2 \end{cases} \qquad (1)$$

$X_A$ et $Y_A$ sont les coordonnées cartésiennes du vecteur $\vec{I}_A$ dans le repère orthonormé précité, dont seule l'origine O est représentée dans un souci de clarté.

$X_B$ et $Y_B$ sont les coordonnées cartésiennes du vecteur $\vec{I}_B$ dans le même repère orthonormé.

$X_S$ et $Y_S$ sont deux inconnues et sont les coordonnées cartésiennes du vecteur $\overrightarrow{OS}$, toujours dans le même repère orthonormé.

Le dispositif calculateur 15 peut résoudre le système (1) de deux équations à deux inconnues au moyen d'une méthode mathématique de résolution numérique qui est basée sur une variation progressive de $X_S$ et $Y_S$, en étant contrôlée par un critère de convergence pertinent.

Par exemple, une méthode numérique de détermination du point S peut consister à se déplacer pas à pas sur l'un des deux cercles précités, qui sont le cercle de centre A et de rayon l'intensité $I_{3A}$ et le cercle de centre B et de rayon l'intensité $I_{3B}$. A chaque pas sur l'un des cercles, on vérifie si l'on se trouve ou non dans le voisinage immédiat de l'autre cercle.

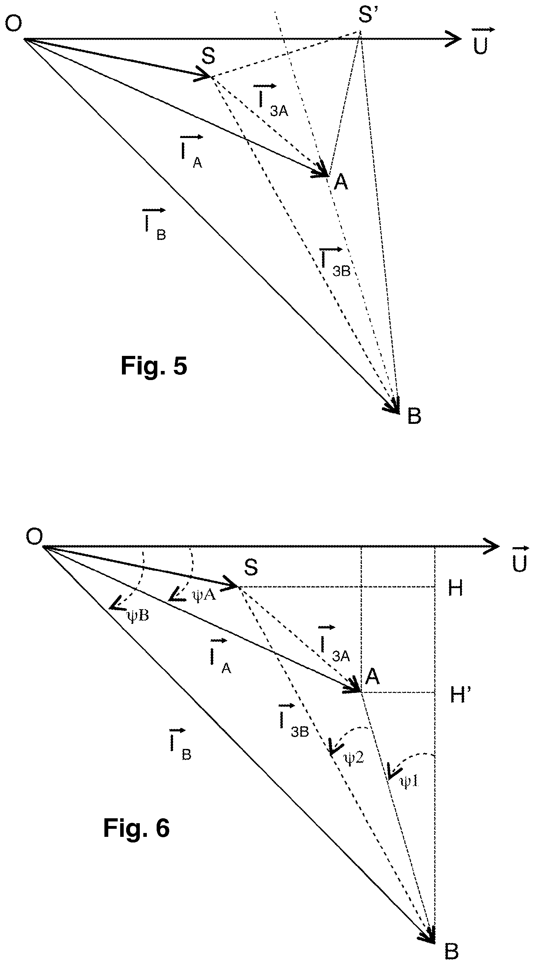

Il convient de noter que le système (1) possède deux solutions qui correspondent aux points S et S' à la figure 5. Le point S' correspond à une solution aberrante physiquement, qui doit être éliminée pour ne conserver que l'autre solution, celle correspondant au point S.

L'élimination du point S' peut se faire en calculant, pour chacun des points S et S', les puissances actives et réactives avant et après la variation de puissance observée et en ne retenant que celui des deux points S et S' pour lequel ces puissances répondent aux critères suivants :

- les puissances actives avant et après la variation de puissance doivent être positives, étant considéré que les charges 5c sont supposées consommer et non pas fournir de la puissance active,

- les puissances réactives avant et après la variation de puissance doivent être de même signe et cohérentes avec la nature de la ou des charges 5c dans la branche 4, à savoir positives en cas de charges 5c capacitives et négatives en cas de charge 5c selfiques.

Une fois que le point S est déterminé, on détermine aisément le vecteur $\vec{I}_{3B}$ et les valeurs d'intensité et de déphasage caractéristiques du nouveau courant $I_3$, au moyen de la relation suivante : $\vec{I}_{3B} = \vec{I}_B \text{-} \overrightarrow{OS}$.

La nouvelle puissance $P_{3B}$, c'est-à-dire celle postérieure au changement et consommée dans la branche 4 où circule le courant $I_3$, est ensuite calculée par le dispositif calculateur 15, comme étant le produit scalaire des vecteurs $\vec{U}$ et $\vec{I}_{3B}$ : $P_{3B} = \vec{U} \bullet \vec{I}_{3B}$. L'ancienne puissance $P_{3A}$ dans cette branche 4 peut également être calculée, de manière semblable, à savoir au moyen de la relation $P_{3A} = \vec{U} \bullet \vec{I}_{3A}$.

La figure 6 illustre des relations géométriques et trigonométriques qui sont employées dans une deuxième façon de procéder pour déterminer la puissance consommée dans la branche 4 où circule le courant $I_3$. A la place ou en complément de la première façon de procéder exposée précédemment, le dispositif calculateur 15 peut mettre en oeuvre cette deuxième façon de procéder, qui repose sur un calcul analytique et qui va maintenant être exposée.

Dans le triangle AOB visible à la figure 6, on a la relation suivante :

$$AB^2 = I_A^2 + I_B^2 - 2 \times I_A \times I_B \times \cos(angle AOB) \qquad (2)$$

$I_A$ et $I_B$ sont respectivement une mesure de l'intensité de l'ancien courant global I (avant le changement) et une mesure de l'intensité du nouveau courant global I (après le changement).

De la relation (2), on déduit l'égalité suivante :

$$AB = \sqrt{I_A^2 + I_B^2 - 2 \times I_A \times I_B \times \cos\left(\psi_B - \psi_A\right)} \qquad (3)$$

$\psi_A$ et $\psi_B$ sont respectivement une mesure du déphasage de l'ancien courant global I et une mesure du déphasage du nouveau courant global I.

Selon la deuxième façon de procéder, le dispositif calculateur 15 détermine la valeur d'intensité AB au moyen de l'égalité (3).

Par ailleurs, on a la relation suivante :

$$P_B - P_A = U \times AB \times \sin(\psi_1) \qquad (4)$$

$P_A$ est l'ancienne puissance globale consommée par l'installation électrique 1, c'est-à-dire par l'ensemble des branches 4, telle que mesurée par le compteur 6 avant le changement. $P_B$ est la nouvelle puissance globale consommée par cette installation électrique 1, telle que mesurée par le compteur 6 après le changement. U est une mesure de la tension globale aux bornes du groupe de branches 4.

De la relation (4), on déduit l'égalité suivante :

$$\psi_1 = \arcsin\left(\frac{I_B \times \cos\psi_B - I_A \times \cos\psi_A}{AB}\right) \qquad (5)$$

Selon la deuxième façon de procéder, le dispositif calculateur 15 détermine la valeur d'angle $\psi_1$ au moyen de l'égalité (5).

Dans le triangle ABS visible à la figure 6, on a la relation suivante :

$$SA^2 = SB^2 + AB^2 - 2 \times SB \times AB \times cos\psi_2 \qquad (6)$$

De la relation (6), on déduit l'égalité suivante :

$$\psi_2 = \arccos\left(\frac{I_{3B}^2 + AB^2 - I_{3A}^2}{2 \times I_{3B} \times AB}\right) \qquad (7)$$

Selon la deuxième façon de procéder, le dispositif calculateur 15 détermine la valeur d'angle $\psi_2$ au moyen de l'égalité (7).

Par ailleurs, on a la relation suivante :

$$SH = SB \times \sin(\psi_1 + \psi_2) \qquad (8)$$

De la relation (8), on déduit l'égalité suivante :

$$P_{3B} = U \times I_{3B} \times \sin(\psi_1 + \psi_2) \qquad (9)$$

Selon la deuxième façon de procéder, le dispositif calculateur 15 utilise l'égalité (9) pour déterminer la nouvelle puissance individuelle $P_{3B}$ dans la branche 4 où circule le courant $I_3$.

Bien entendu, les formules employées peuvent présenter une autre forme que les égalités (3), (5), (7) et (9), tout en restant dans le cadre de la deuxième façon de procéder qui vient d'être exposée. Par exemple, les égalités (3), (5), (7) et (9) peuvent être combinées dans le sens d'une réduction du nombre de formules employées. Notamment, l'égalité (3) peut être incorporée dans l'égalité (5), ainsi que dans l'égalité (7), tandis que ces égalités (5) et (7) peuvent être incorporées dans l'égalité (9).

Le dispositif calculateur 15 peut également déterminer le déphasage $\psi_{3B}$ du nouveau courant $I_3$, c'est-à-dire du courant $I_3$ après le changement, au moyen de la relation suivante :

$$\psi_{3B} = \pi/2 - (\psi_1 + \psi_2) \qquad (10)$$

Le dispositif calculateur 15 peut également déterminer l'ancienne puissance individuelle $P_{3A}$, c'est-à-dire la puissance consommée avant le changement, dans la branche 4 où circule le courant $I_3$. Pour ce faire, il peut employer la relation suivante :

$$P_{3A} = P_{3B} - (P_B - P_A) \qquad (11)$$

Le dispositif calculateur 15 peut également déterminer la nouvelle puissance individuelle réactive $Q_{3B}$, c'est-à-dire la puissance réactive après le changement, dans la branche 4 où circule le courant $I_3$. Pour ce faire, il peut employer la relation suivante :

$$Q_{3B} = U \times I_{3B} \times \cos(\psi_1 + \psi_2) \qquad (12)$$

Le dispositif calculateur 15 peut également déterminer l'ancienne puissance individuelle réactive $Q_{3A}$, c'est-à-dire la puissance réactive avant le changement, dans la branche 4 où circule le courant $I_3$. Pour ce faire, il peut employer la relation suivante :

$$Q_{3A} = Q_{3B} - (Q_B - Q_A) \qquad (13)$$

Comme la première façon de procéder utilisant une résolution numérique, la deuxième façon de procéder reposant sur une résolution trigonométrique donne deux solutions qui correspondent aux points S et S' de la figure 5. Ces deux solutions viennent de ce que le calcul d'arcsinus dans la formule (5) peut se voir attribuer une valeur positive ou négative. La solution aberrante correspondant au point S' est éliminée dans la deuxième façon de procéder comme elle l'est dans la première façon de procéder.

A partir de son exposé ci-dessus dans le cas du monophasé, la manière 30 de déterminer une puissance individuelle peut être transposée sans difficulté particulière au cas d'une installation électrique pour courants polyphasés.

Dans un souci de clarté, sa transposition à ce cas d'une installation électrique pour courants polyphasés n'est pas détaillée dans ce qui suit.

La manière 31 de déterminer une puissance individuelle est appropriée dans le cas d'une branche 4 qui est équipée d'un détecteur de courant ou d'un autre moyen de détection du passage ou de l'absence de passage d'un courant et qui possède une charge d'impédance fixe. Dans l'exemple représenté, la manière 31 de déterminer une puissance individuelle convient pour évaluer la puissance individuelle consommée par la charge 5b. Dans cette manière 31, la puissance individuelle dans la branche 4 comportant la charge 5b est calculée comme étant égale à la variation de la puissance globale au moment d'un changement de la consommation dans cette branche 4, si l'on détecte le passage d'un courant $I_2$ après le changement. La puissance globale est la puissance consommée par l'ensemble des branches 4. Elle est mesurée par le compteur de consommation 6 ou à partir des mesures effectuées par celui-ci. Lorsqu'aucun courant $I_2$ n'est détecté, la puissance consommée dans la branche 4 comportant la charge 5b est considérée comme étant nulle.

La manière 32 de déterminer une puissance individuelle est employée dans le cas d'une charge dont l'impédance non constante peut varier progressivement. Dans l'exemple représenté, la manière 32 de déterminer une puissance individuelle est utilisée pour déterminer la puissance individuelle consommée par la charge 5d. Dans cette manière 32, la puissance individuelle dans la branche 4 comportant la charge 5d est mesurée par le compteur de consommation 9 ou déduite des mesures effectuées par celui-ci.

Avantageusement, le compteur de consommation 9 peut être calibré en utilisant des mesures effectuées par le compteur de consommation 6 et le calcul simplifié 41 que comprend la manière 30 de déterminer une puissance individuelle. La calibration du compteur de consommation 9 peut présenter la forme d'une correction effectuée par le dispositif calculateur 15, au niveau de ce dispositif calculateur, sur les mesures reçues, et non au niveau du compteur de consommation 9. Cette calibration peut avoir lieu lors de la première mise en service du compteur de consommation 9 dans l'installation électrique 1, puis à intervalles réguliers. Grâce à cela, le compteur de consommation 9 peut manquer d'exactitude dès lors qu'il produit une mesure fidèle. En particulier, le compteur 9 peut ne pas être calibré en usine et il peut être moins coûteux.

La manière 33 de déterminer une puissance individuelle est appropriée dans le cas d'une branche 4 qui possède une charge d'impédance fixe et unique dans toute l'installation électrique 1. Dans l'exemple représenté, la manière 33 de déterminer une puissance individuelle convient pour évaluer la puissance individuelle consommée par la charge 5a. Dans cette manière 33, la puissance individuelle dans la branche 4 comportant la charge 5a est calculée comme étant égale à une variation de la puissance globale dans l'ensemble des branches 4, si cette variation est de signe positif et de l'ordre de l'unique puissance que la charge 5a peut consommer. Lorsqu'une variation de la puissance globale est de signe négatif et qu'elle est de l'ordre de cette unique puissance, la puissance consommée dans la branche 4 comportant la charge 5a est considérée comme étant nulle.

L'énergie individuelle consommée dans une branche 4 est calculée en intégrant dans le temps la puissance individuelle qui a été évaluée ou mesurée dans cette branche 4 par l'une des manières 30 à 33. L'intégration des puissances individuelles dans le temps utilise un enregistrement de la chronologie des changements de consommation de puissance dans les branches 4.

Selon une alternative conforme à l'invention, l'installation électrique 1 est une installation en courant continu, qui est raccordée à une alimentation électrique 2 fournissant une tension continue. Dans ce cas, l'instrumentation de mesure et de détection est adaptée en conséquence, tandis que l'étape 42 est simplifiée. Bien entendu, il n'y a pas de déphasage à mesurer ni à déterminer d'une autre manière. Dans l'étape 42 simplifiée, la puissance consommée dans la branche 4 parcourue par le courant $I_3$ est déterminée à partir d'une mesure de l'intensité de ce courant $I_3$ et d'une mesure de la tension globale U d'alimentation du groupe de branches 4, comme étant le produit de l'une par l'autre. La puissance dans la branche 4 parcourue par le courant $I_4$ peut être obtenue de la même manière, si bien que cette branche 4 peut n'être équipée que d'un ampèremètre. La manière 31 de déterminer une puissance individuelle est semblable en courant alternatif et en courant continu. Il en est de même de la manière 33 de déterminer une puissance individuelle.

L'invention ne se limite pas aux modes de réalisation décrits précédemment. En particulier, lorsqu'elle est utilisée dans le cadre d'une alimentation en courant alternatif, l'invention ne se limite pas au cas du monophasé, mais peut au contraire également être mise en oeuvre dans des installations électriques pour courants polyphasés. De plus, le domaine de l'invention couvre aussi bien la moyenne et la haute tension que la basse tension, même si l'exemple décrit précédemment se situe dans le domaine de la basse tension.

## Revendications

1.  Procédé de détermination d'une consommation d'énergie électrique, dans une installation électrique (1) comprenant un groupe de plusieurs branches (4) de distribution individuelle d'électricité entre plusieurs charges (5a, 5b, 5c, 5d), ainsi qu'une ligne principale amont (3) raccordant le groupe de branches (4) à une alimentation électrique (2), le procédé comprenant l'action d'effectuer dans le temps et d'enregistrer des mesures (U, $I_A$, $I_B$, $\psi_A$, $\psi_B$) prises au niveau de la ligne principale amont (3) et permettant d'établir la puissance globale et l'énergie consommée par le groupe de branches, le procédé comportant des étapes dans lesquelles :

a) on détecte un changement quant à la consommation électrique dans l'installation (1), et

b) on relève une information relative à un courant électrique ($I_2$, $I_3$, $I_4$) dans une branche particulière parmi lesdites branches (4), à l'aide d'un transducteur (7, 8, 9) équipant cette branche particulière, puis

c) au moyen de l'information relevée à l'aide du transducteur (7, 8, 9) équipant la branche particulière (4), on établit une indication selon laquelle ledit changement s'est produit au niveau de cette branche particulière (4), puis

d) en utilisant à la fois des données parmi les mesures (U, $I_A$, $\psi_A$) prises au niveau de la ligne principale amont avant le changement et des données parmi les mesures (U, $I_B$, $\psi_B$) prises au niveau de la ligne principale amont après le changement, ainsi que ladite indication, on détermine une consommation individuelle particulière d'énergie dans ladite branche particulière (4),

ledit procédé étant **caractérisé en ce que** ladite étape d) comporte des sous-étapes dans lesquelles :

- d1) en combinant ladite indication et une table (18) établissant au moins une correspondance entre au moins une catégorie de la branche particulière (4), ladite catégorie étant définie en fonction du type des charges dans la branche particulière (4) et la manière dont ladite branche particulière (4) est instrumentée, et au moins une manière d'un jeu de plusieurs manières (30, 31, 32) de déterminer une consommation individuelle d'énergie dans une branche, on sélectionne une manière adaptée à la catégorie de la branche particulière (4) dans le jeu de manières de déterminer une consommation individuelle,

- d2) en utilisant la manière sélectionnée (30, 31, 32), on détermine la consommation individuelle particulière d'énergie de la branche particulière (4),

lesdites branches de distribution individuelle (4) étant connectées en parallèle, l'alimentation électrique (2) étant en courant alternatif, dans au moins une branche spécifique (4) du groupe de branches correspondant à une catégorie ou les changements de consommation de puissance se font par palier et dans laquelle circule un courant individuel spécifique ($I_3$), une manière spécifique (30) du jeu comprenant l'action d'effectuer dans le temps et d'enregistrer des mesures d'une tension globale (U) d'alimentation du groupe de plusieurs branches (4), des mesures des valeurs d'intensité et de déphasage ($I_A$, $I_B$, $\psi_A$, $\psi_B$) d'un courant global (I) d'alimentation du groupe de plusieurs branches (4), ainsi que des mesures de l'intensité ($I_{3A}$, $I_{3B}$) du courant individuel spécifique ($I_3$) circulant dans la branche spécifique (4) du groupe de branches, la manière spécifique (30) comportant une étape dans laquelle :

e) en utilisant une mesure de la tension globale (U) sensiblement constante pendant le changement, des mesures des valeurs d'intensité et de déphasage ($I_A$, $I_B$, $\psi_A$, $\psi_B$) du courant global (I) avant et après le changement, ainsi que des mesures des intensités ($I_{3A}$, $I_{3B}$) du courant individuel spécifique ($I_3$) avant et après le changement, on détermine une puissance individuelle pour calculer une énergie consommée dans la branche spécifique (4).

2. Procédé selon la revendication 1, **caractérisé en ce que**, dans l'étape e), on détermine la puissance individuelle en considérant que l'ensemble ($I_1$, $I_2$, $I_4$) des courants individuels circulant dans les branches (4) du groupe à l'exception du courant individuel spécifique ($I_3$) s'additionnent en une somme sensiblement inchangée à l'issue du changement, par rapport à avant le changement, et que doivent être simultanément satisfaites deux conditions qui sont :

- que le courant global (I) avant le changement doit être sensiblement égal à l'ajout de la somme sensiblement inchangée au courant individuel spécifique ($I_3$) avant le changement, et
- que le courant global (I) après le changement doit être sensiblement égal à l'ajout de la somme sensiblement inchangée au courant individuel spécifique ($I_3$) après le changement.

3. Procédé selon l'une quelconque des revendications 1 ou 2, **caractérisé en ce que**, dans l'étape e), on élimine une solution aberrante (S') parmi deux solutions possibles (S, S').

4. Procédé de détermination d'une consommation d'énergie selon la revendication 1, **caractérisé en ce que** les branches de distribution individuelle (4) sont connectées en parallèle, l'alimentation électrique (2) étant en courant continu, une manière spécifique (30) du jeu comprenant l'action d'effectuer des mesures d'une tension globale (U) d'alimentation du groupe de plusieurs branches (4), ainsi que des mesures de l'intensité d'un courant individuel spécifique (I$_3$) circulant dans une branche spécifique (4) du groupe de branches, la manière spécifique comportant une étape dans laquelle :

    e) en utilisant une mesure de la tension globale (U) et une mesure de l'intensité du courant individuel spécifique (I$_3$), on détermine une puissance individuelle pour calculer une énergie consommée dans la branche spécifique (4).

**5.** Procédé de détermination d'une consommation d'énergie selon l'une quelconque des revendications 1 à 4, **caractérisé en ce que**, dans l'une (30, 31) des manières de déterminer une consommation individuelle d'énergie, on détermine une puissance individuelle dans l'une des branches (4) comme étant égale à la différence (4) entre une puissance globale dans le groupe de branches avant le changement et une puissance globale dans le groupe de branches après ce changement.

**6.** Système de supervision d'un groupe de plusieurs branches (4) de distribution individuelle d'électricité entre plusieurs charges dans une installation électrique (1), comportant au moins :

    - un dispositif (6) de réalisation de mesures (U, I$_A$, I$_B$, $\psi_A$, $\psi_B$) au niveau d'une ligne principale amont (3) raccordant le groupe de branches (4) à une alimentation électrique (2),
    - une mémoire (14) d'enregistrement de ces mesures (U, I$_A$, I$_B$, $\psi_A$, $\psi_B$) qui permettent d'établir la puissance globale consommée par le groupe de branches (4),
    - un transducteur (7, 8, 9) d'équipement d'une branche particulière parmi les branches (4),
    - un dispositif calculateur (15, 18) à même :

        - de détecter un changement quant à la consommation électrique dans l'installation (1), en communiquant avec l'un au moins des dispositifs que sont le dispositif de réalisation de mesure (6) et le transducteur (7, 8, 9), et
        - de surveiller une information relative à un courant électrique (I2, I3, I4) dans la branche particulière (4), en provenance du transducteur (7, 8, 9) équipant cette branche particulière (4), puis
        - au moyen de l'information en provenance du transducteur (7, 8, 9) équipant la branche particulière (4), d'établir une indication selon laquelle ledit changement s'est produit au niveau de cette branche particulière (4), puis
        - en utilisant à la fois des données parmi les mesures (U, I$_A$, $\psi_A$) prises au niveau de la ligne principale amont avant le changement et des données parmi les mesures (U, I$_B$, $\psi_B$) prises au niveau de la ligne principale amont après le changement, ainsi que ladite indication, de déterminer une consommation individuelle particulière d'énergie dans ladite branche particulière (4),
        ledit dispositif calculateur (15) étant **caractérisé en ce qu'**il possède plusieurs manières (30, 31, 32) de déterminer une consommation individuelle d'énergie dans une branche et une table (18) pour établir au moins une correspondance entre l'une au moins des catégories des branches (4) et l'une au moins des manières (30, 31, 32), le dispositif calculateur (15, 18) étant à même de sélectionner une manière spécifique (30, 31, 32) parmi les manières de déterminer une consommation individuelle, en combinant ladite indication et la table (18), et de déterminer la consommation individuelle particulière d'énergie en utilisant la manière spécifique sélectionnée (30, 31, 32) adaptée à la catégorie de la branche (4),

ledit système de supervision (6, 7, 8, 9, 11, 12) étant adapté pour effectuer dans le temps et enregistrer des mesures d'une tension globale (U) d'alimentation du groupe de plusieurs branches (4), des mesures des valeurs d'intensité et de déphasage (IA, IB, $\psi$A, $\psi$B) d'un courant global (I) d'alimentation du groupe de plusieurs branches (4), ainsi que des mesures de l'intensité (I3A, I3B) d'un courant individuel spécifique (I$_3$) circulant dans une branche spécifique (4) du groupe de branches, et **en ce que** le dispositif calculateur comprend un moyen de détermination d'une puissance individuelle dans la branche spécifique (4), en utilisant une mesure de la tension globale (U) sensiblement constante pendant le changement, des mesures des valeurs d'intensité et de déphasage (IA, IB, $\psi$A, $\psi$B) du courant global (I) avant et après le changement, ainsi que des mesures des intensités (I3A, I3B) du courant individuel spécifique (I3) avant et après le changement.

**7.** Système de supervision selon la revendication 6, **caractérisé en ce que** le moyen de détermination d'une puissance individuelle est adapté pour déterminer cette puissance individuelle en considérant que l'ensemble (I$_1$, I$_2$, I$_3$) des courants individuels circulant dans les branches (4) du groupe à l'exception du courant individuel spécifique (I$_3$) s'additionnent en une somme sensiblement inchangée à l'issue du changement, par rapport à avant le changement, et que doivent être simultanément satisfaites deux conditions qui sont :

- que le courant global (I) avant le changement doit être sensiblement égal à l'ajout de la somme sensiblement inchangée au courant individuel spécifique ($I_3$) avant le changement, et
- que le courant global (I) après le changement doit être sensiblement égal à l'ajout de la somme sensiblement inchangée au courant individuel spécifique ($I_3$) après le changement.

8. Système de supervision selon la revendication 7, **caractérisé en ce que** le dispositif calculateur comprend un moyen d'élimination d'une solution aberrante (S') parmi deux solutions possibles (S, S').

9. Système de supervision selon l'une quelconque des revendications 6 à 8, **caractérisé en ce que** le dispositif calculateur comprend un moyen de détermination d'une puissance individuelle dans l'une des branches (4) comme étant égale à la différence entre une puissance globale dans le groupe de branches (4) avant le changement et une puissance globale dans le groupe de branches (4) après ce changement.

10. Système de supervision selon l'une quelconque des revendications 6 à 9, **caractérisé en ce que** le dispositif calculateur (8, 9, 11, 12) est à même de conduire un procédé selon l'une quelconque des revendications 1 à 5.

11. Installation électrique, comportant un groupe de plusieurs branches (4) de distribution individuelle d'électricité entre plusieurs charges (5a, 5b, 5c, 5d), une ligne principale amont (3) raccordant le groupe de branches à une alimentation électrique (2), **caractérisée en ce qu'**elle comporte un système de supervision (6, 7, 8, 9, 12) selon l'une quelconque des revendications 6 à 10, le dispositif de réalisation de mesures (6) équipant la ligne principale amont (3), une branche particulière (4) parmi les branches étant équipée du transducteur (7, 8, 9).

**Patentansprüche**

1. Verfahren zur Bestimmung eines Stromverbrauchs in einer elektrischen Anlage (1), die eine Gruppe aus mehreren Zweigen (4) zur Stromeinzelverteilung zwischen mehreren Lasten (5a, 5b, 5c, 5d) sowie eine vorgelagerte Hauptleitung (3), welche die Gruppe von Zweigen (4) mit einer Stromversorgung (2) verbindet, umfasst, wobei das Verfahren den Vorgang umfasst, im Laufe der Zeit Messungen (U, $I_A$, $I_B$, $\psi_A$, $\psi_B$) durchzuführen, die an der vorgelagerten Hauptleitung (3) abgegriffen werden und es ermöglichen, die Gesamtleistung und die von der Gruppe von Zweigen verbrauchte Energie festzustellen, wobei das Verfahren Schritte umfasst, in denen:

a) eine den Stromverbrauch in der Anlage (1) betreffende Änderung detektiert wird und
b) eine Information über einen elektrischen Strom ($I_2$, $I_3$, $I_4$) in einem besonderen Zweig unter den Zweigen (4) mithilfe eines Wandlers (7, 8, 9), mit dem dieser besondere Zweig ausgestattet ist, erfasst wird, dann
c) mittels der Information, die mithilfe des Wandlers (7, 8, 9) erfasst wurde, mit dem der besondere Zweig (4) ausgestattet ist, ein Hinweis festgestellt wird, demzufolge die Änderung an diesem besonderen Zweig (4) eingetreten ist, dann
d) unter Verwendung sowohl der Daten unter den Messungen (U, $I_A$, $\psi_A$), die an der vorgelagerten Hauptleitung vor der Änderung abgegriffen wurden, und der Daten unter den Messungen (U, $I_B$, $\psi_B$), die an der vorgelagerten Hauptleitung nach der Änderung abgegriffen wurden, sowie des Hinweises ein besonderer Stromeinzelverbrauch in dem besonderen Zweig (4) bestimmt wird,

wobei das Verfahren **dadurch gekennzeichnet ist, dass** der Schritt d) Teilschritte umfasst, in denen:

- d1) durch Kombinieren des Hinweises und einer Tabelle (18), die mindestens eine Entsprechung zwischen mindestens einer Kategorie des besonderen Zweiges (4), wobei die Kategorie in Abhängigkeit vom Typ der Lasten in dem besonderen Zweig (4) und der Art, wie der besondere Zweig (4) instrumentiert ist, definiert wird, und mindestens einem Satz aus mehreren Arten (30, 31, 32) der Bestimmung eines Stromeinzelverbrauchs in einem Zweig feststellt, eine Art ausgewählt wird, die für die Kategorie des besonderen Zweigs (4) in dem Satz von Arten der Bestimmung eines Stromverbrauchs geeignet ist,
- d2) unter Verwendung der ausgewählten Art (30, 31, 32) der besondere Stromeinzelverbrauch des besonderen Zweigs (4) bestimmt wird,

wobei die Einzelverteilungszweige (4) parallel angeschlossen sind, wobei die Stromversorgung (2) eine Wechselstromversorgung ist, wobei in mindestens einem spezifischen Zweig (4) der Gruppe von Zweigen, der einer Kategorie entspricht, bei der die Leistungsverbrauchsänderungen stufenweise stattfinden, und in dem ein spezifischer Einzelstrom ($I_3$) fließt, eine spezifische Art (30) des Satzes den Vorgang umfasst, im Laufe der Zeit Messungen einer Gesamtspeisespannung (U) der Gruppe aus mehreren Zweigen (4), Messungen der Stärke- und Phasenverschiebungswerte ($I_A$, $I_B$, $\psi_A$, $\psi_B$) eines Gesamtspeisestroms (I) der Gruppe aus mehreren Zweigen (4) sowie Messungen der Stärke ($I_{3A}$, $I_{3B}$) des spezifischen Einzelstroms ($I_3$), der in dem spezifischen Zweig (4) der Gruppe von Zweigen fließt, durchzuführen und aufzuzeichnen, wobei die spezifische Art (30) einen Schritt umfasst, in dem:

e) unter Verwendung einer Messung der Gesamtspannung (U), die während der Änderung im Wesentlichen konstant ist, der Messungen der Stärke- und Phasenverschiebungswerte ($I_A$, $I_B$, $\psi_A$, $\psi_B$) des Gesamtstroms (I) vor und nach der Änderung sowie der Messungen der Stärken ($I_{3A}$, $I_{3B}$) des spezifischen Einzelstroms ($I_3$) vor und nach der Änderung eine Einzelleistung bestimmt wird, um einen Stromverbrauch in dem spezifischen Zweig (4) zu berechnen.

2. Verfahren nach Anspruch 1, **dadurch gekennzeichnet, dass** im Schritt e) die Einzelleistung bestimmt wird, indem davon ausgegangen wird, dass die Gesamtheit ($I_1$, $I_2$, $I_4$) der in den Zweigen (4) der Gruppe fließenden Einzelströme, mit Ausnahme des spezifischen Einzelstroms ($I_3$), sich zu einer Summe addiert, die nach der Änderung im Vergleich zu vor der Änderung im Wesentlichen unverändert ist, und dass zwei Bedingungen gleichzeitig erfüllt sein müssen, die sind:

- dass der Gesamtstrom (I) vor der Änderung im Wesentlichen gleich dem Hinzufügen der im Wesentlichen unveränderten Summe zum spezifischen Einzelstrom ($I_3$) vor der Änderung sein muss und
- dass der Gesamtstrom (I) nach der Änderung im Wesentlichen gleich dem Hinzufügen der im Wesentlichen unveränderten Summe zum spezifischen Einzelstrom ($I_3$) nach der Änderung sein muss.

3. Verfahren nach einem der Ansprüche 1 oder 2, **dadurch gekennzeichnet, dass** im Schritt e) eine abwegige Lösung (S') unter zwei möglichen Lösungen (S, S') eliminiert wird.

4. Verfahren zur Bestimmung eines Stromverbrauchs nach Anspruch 1, **dadurch gekennzeichnet, dass** die Einzelverteilungszweige (4) parallel angeschlossen sind, wobei die Stromversorgung (2) eine Gleichstromversorgung ist, wobei eine spezifische Art (30) des Satzes den Vorgang umfasst, Messungen einer Gesamtspeisespannung (U) der Gruppe aus mehreren Zweigen (4) sowie Messungen der Stärke eines spezifischen Einzelstroms ($I_3$), der in einem spezifischen Zweig (4) der Gruppe aus Zweigen fließt, durchzuführen, wobei die spezifische Art einen Schritt umfasst, in dem:

e) unter Verwendung einer Messung der Gesamtspannung (U) und einer Messung der Stärke des spezifischen Einzelstroms ($I_3$) eine Einzelleistung bestimmt wird, um einen Stromverbrauch in dem spezifischen Zweig (4) zu berechnen.

5. Verfahren zur Bestimmung eines Stromverbrauchs nach einem der Ansprüche 1 bis 4, **dadurch gekennzeichnet, dass** bei einer (30, 31) der Arten der Bestimmung eines Einzelstromverbrauchs eine Einzelleistung in einem der Zweige (4) bestimmt wird als gleich der Differenz (4) zwischen einer Gesamtleistung in der Gruppe aus Zweigen vor der Änderung und einer Gesamtleistung in der Gruppe von Zweigen nach dieser Änderung.

6. Überwachungssystem einer Gruppe aus mehreren Zweigen (4) zur Stromeinzelverteilung zwischen mehreren Lasten in einer elektrischen Anlage (1), umfassend mindestens:

- eine Vorrichtung (6) zur Ausführung von Messungen (U, $I_A$, $I_B$, $\psi_A$, $\psi_B$) an einer vorgelagerten Hauptleitung (3), die die Gruppe von Zweigen (4) an eine Stromversorgung (2) anschließt,
- einen Speicher (14) zur Aufzeichnung dieser Messungen (U, $I_A$, $I_B$, $\psi_A$, $\psi_B$), die es ermöglichen, die von der Gruppe von Zweigen (4) verbrauchte Gesamtleistung festzustellen,
- einen Wandler (7, 8, 9) zur Ausstattung eines besonderen Zweiges unter den Zweigen (4),
- eine Rechnervorrichtung (15, 18), die imstande ist:

- eine den Stromverbrauch in der Anlage (1) betreffende Änderung zu detektieren, indem sie mit mindestens einer der Vorrichtungen, die die Vorrichtung zur Ausführung von Messungen (6) und der Wandler (7, 8, 9) sind, kommuniziert, und
- eine Information bezüglich eines elektrischen Stroms ($I_2$, $I_3$, $I_4$) in dem besonderen Zweig (4), die von dem Wandler (7, 8, 9) kommt, mit dem dieser besondere Zweig (4) ausgestattet ist, zu überwachen, dann

- mittels der Information, die von dem Wandler (7, 8, 9) kommt, mit dem der besondere Zweig (4) ausgestattet ist, einen Hinweis festzustellen, demzufolge diese Änderung auf Ebene dieses besonderen Zweiges (4) eingetreten ist, dann

- unter Verwendung sowohl der Daten unter den Messungen $(U, I_A, \psi_A)$, die an der vorgelagerten Hauptleitung vor der Änderung abgegriffen wurden, und der Daten unter den Messungen $(U, I_B, \psi_B)$, die an der vorgelagerten Hauptleitung nach der Änderung abgegriffen wurden, sowie des Hinweises einen besonderen Stromeinzelverbrauch in dem besonderen Zweig (4) zu bestimmen,

wobei die Rechnervorrichtung (15) **dadurch gekennzeichnet ist, dass** sie mehrere Arten (30, 31, 32) der Bestimmung eines Stromeinzelverbrauchs in einem Zweig besitzt und eine Tabelle (18), um mindestens eine Entsprechung zwischen der mindestens einen der Kategorien der Zweige (4) und der mindestens einen der Arten (30, 31, 32) festzustellen, wobei die Rechnervorrichtung (15, 18) imstande ist, eine spezifische Art (30, 31, 32) unter den Arten der Bestimmung eines Einzelverbrauchs auszuwählen, indem sie den Hinweis und die Tabelle (18) kombiniert, und den besonderen Stromeinzelverbrauch zu bestimmen, indem sie die ausgewählte spezifische Art (30, 31, 32) verwendet, die für die Kategorie des Zweigs (4) geeignet ist,

wobei das Überwachungssystem (6, 7, 8, 9, 11, 12) geeignet ist, im Laufe der Zeit Messungen einer Gesamtspeisespannung (U) der Gruppe aus mehreren Zweigen (4), Messungen der Stärke- und Phasenverschiebungswerte $(I_A, I_B, \psi_A, \psi_B)$ eines Gesamtspeisestroms (I) der Gruppe aus mehreren Zweigen (4) sowie Messungen der Stärke $(I_{3A}, I_{3B})$ eines spezifischen Einzelstroms $(I_3)$, der in einem spezifischen Zweig (4) der Gruppe von Zweigen fließt, durchzuführen und aufzuzeichnen, und dass die Rechnervorrichtung ein Mittel zum Bestimmen einer Einzelleistung in dem spezifischen Zweig (4) umfasst, indem eine Messung der Gesamtspannung (U), die während der Änderung im Wesentlichen konstant ist, Messungen der Stärke- und Phasenverschiebungswerte $(I_A, I_B, \psi_A, \psi_B)$ des Gesamtstroms (I) vor und nach der Änderung sowie Messungen der Stärken $(I_{3A}, I_{3B})$ des spezifischen Einzelstroms $(I_3)$ vor und nach der Änderung verwendet werden.

7. Überwachungssystem nach Anspruch 6, **dadurch gekennzeichnet, dass** das Mittel zum Bestimmen einer Einzelleistung geeignet ist, diese Einzelleistung zu bestimmen, indem es davon ausgeht, dass die Gesamtheit $(I_1, I_2, I_3)$ der in den Zweigen (4) der Gruppe fließenden Einzelströme, mit Ausnahme des spezifischen Einzelstroms $(I_3)$, sich zu einer Summe addiert, die nach der Änderung im Vergleich zu vor der Änderung im Wesentlichen unverändert ist, und dass zwei Bedingungen gleichzeitig erfüllt sein müssen, die sind:

- dass der Gesamtstrom (I) vor der Änderung im Wesentlichen gleich dem Hinzufügen der im Wesentlichen unveränderten Summe zum spezifischen Einzelstrom $(I_3)$ vor der Änderung sein muss und
- dass der Gesamtstrom (I) nach der Änderung im Wesentlichen gleich dem Hinzufügen der im Wesentlichen unveränderten Summe zum spezifischen Einzelstrom $(I_3)$ nach der Änderung sein muss.

8. Überwachungssystem nach Anspruch 7, **dadurch gekennzeichnet, dass** die Rechnervorrichtung ein Mittel zum Eliminieren einer abwegigen Lösung (S') unter zwei möglichen Lösungen (S, S') umfasst.

9. Überwachungssystem nach einem der Ansprüche 6 bis 8, **dadurch gekennzeichnet, dass** die Rechnervorrichtung ein Mittel zum Bestimmen einer Einzelleistung in einem der Zweige (4) als gleich der Differenz zwischen einer Gesamtleistung in der Gruppe aus Zweigen (4) vor der Änderung und einer Gesamtleistung in der Gruppe von Zweigen (4) nach dieser Änderung umfasst.

10. Überwachungssystem nach einem der Ansprüche 6 bis 9, **dadurch gekennzeichnet, dass** die Rechnervorrichtung (8, 9, 11, 12) imstande ist, ein Verfahren nach einem der Ansprüche 1 bis 5 zu steuern.

11. Elektrische Anlage, umfassend eine Gruppe aus mehreren Zweigen (4) zur Stromeinzelverteilung zwischen mehreren Lasten (5a, 5b, 5c, 5d), wobei eine vorgelagerte Hauptleitung (3) die Gruppe von Zweigen an eine Stromversorgung (2) anschließt, **dadurch gekennzeichnet, dass** sie ein Überwachungssystem (6, 7, 8, 9, 12) nach einem der Ansprüche 6 bis 10 umfasst, wobei die Vorrichtung zur Ausführung von Messungen (6) die vorgelagerte Hauptleitung (3) ausstattet, wobei ein besonderer Zweig (4) unter den Zweigen mit dem Wandler (7, 8, 9) ausgestattet ist.

**Claims**

1. Method for determining a consumption of electrical energy in an electrical installation (1) comprising a group of several branches (4) for individually distributing electricity between several loads (5a, 5b, 5c, 5d), as well as a main upstream line (3) connecting the group of branches (4) to an electric power supply (2), the method comprising the action of performing over time and recording measurements ($U$, $I_A$, $I_B$, $\psi_A$, $\psi_B$) taken on the main upstream line (3) and that make it possible to establish the overall power and the energy consumed by the group of branches, the method including steps in which:

a) a change is detected with regard to the electrical consumption in the installation (1), and
b) an item of information in relation to an electric current ($I_2$, $I_3$, $I_4$) in one particular branch from among said branches (4) is detected using a transducer (7, 8, 9) fitted on this particular branch, and then
c) using the item of information detected using the transducer (7, 8, 9) fitted on the particular branch (4), an indication is established according to which said change has occurred on this particular branch (4), and then
d) using both data from among the measurements ($U$, $I_A$, $\psi_A$) taken on the main upstream line before the change and data from among the measurements ($U$, $I_B$, $\psi_B$) taken on the main upstream line after the change, as well as said indication, a particular individual consumption of energy in said particular branch (4) is determined,

said method being **characterized in that** said step d) includes substeps in which:

- d1) by combining said indication and a table (18) establishing at least one correspondence between at least one category of the particular branch (4), said category being defined on the basis of the type of the loads in the particular branch (4) and the way in which said particular branch (4) is equipped, and at least one way from a set of several ways (30, 31, 32) of determining an individual consumption of energy in a branch, a way suitable for the category of the particular branch (4) is selected from the set of ways for determining an individual consumption,
- d2) using the selected way (30, 31, 32), the particular individual consumption of energy in the particular branch (4) is determined,

said individual distribution branches (4) being connected in parallel, the electric power supply (2) being AC, in at least one specific branch (4) of the group of branches corresponding to a category in which the changes in power consumption occur in increments and in which a specific individual current ($I_3$) is flowing, one specific way (30) from the set comprising the action of performing over time and recording measurements of an overall supply voltage ($U$) of the group of several branches (4), measurements of the magnitude and phase offset values ($I_A$, $I_B$, $\psi_A$, $\psi_B$) of an overall supply current ($I$) of the group of several branches (4), as well as measurements of the magnitude ($I_{3A}$, $I_{3B}$) of the specific individual current ($I_3$) flowing in the specific branch (4) of the group of branches, the specific way (30) including a step in which:

e) using a measurement of the overall voltage ($U$) that is substantially constant during the change, measurements of the magnitude and phase offset values ($I_A$, $I_B$, $\psi_A$, $\psi_B$) of the overall current ($I$) before and after the change, as well as measurements of the magnitudes ($I_{3A}$, $I_{3B}$) of the specific individual current ($I_3$) before and after the change, an individual power is determined in order to calculate energy consumed in the specific branch (4).

2. Method according to Claim 1, **characterized in that**, in step e), the individual power is determined with consideration to the fact that all ($I_1$, $I_2$, $I_4$) of the individual currents flowing in the branches (4) of the group, with the exception of the specific individual current ($I_3$), add together to give a sum that is substantially unchanged at the end of the change, in comparison with before the change, and that two conditions have to be satisfied simultaneously, these being:

- that the overall current ($I$) before the change has to be substantially equal to the addition of the substantially unchanged sum and the specific individual current ($I_3$) before the change, and
- that the overall current ($I$) after the change has to be substantially equal to the addition of the substantially unchanged sum and the specific individual current ($I_3$) after the change.

3. Method according to either one of Claims 1 and 2, **characterized in that**, in step e), one aberrant solution (S') out of two possible solutions (S, S') is eliminated.

4. Method for determining a consumption of energy according to Claim 1, **characterized in that** the individual distribution branches (4) are connected in parallel, the electric power supply (2) being DC, one specific way (30) from the set comprising the action of performing measurements of an overall supply voltage ($U$) of the group of several branches (4), as well as measurements of the magnitude of a specific individual current ($I_3$) flowing in one specific branch (4) of the group of branches, the specific way including a step in which:

> e) using a measurement of the overall voltage (U) and a measurement of the magnitude of the specific individual current ($I_3$), an individual power is determined in order to calculate energy consumed in the specific branch (4).

**5.** Method for determining a consumption of energy according to any one of Claims 1 to 4, **characterized in that**, in one (30, 31) of the ways of determining an individual consumption of energy, an individual power in one of the branches (4) is determined as being equal to the difference (4) between an overall power in the group of branches before the change and an overall power in the group of branches after this change.

**6.** System for supervising a group of several branches (4) for individually distributing electricity between several loads in an electrical installation (1), including at least:

> - a device (6) for carrying out measurements (U, $I_A$, $I_B$, $\psi_A$, $\psi_B$) on a main upstream line (3) connecting the group of branches (4) to an electric power supply (2),
> - a memory (14) for recording these measurements (U, $I_A$, $I_B$, $\psi_A$, $\psi_B$) that make it possible to establish the overall power consumed by the group of branches (4),
> - a transducer (7, 8, 9) fitted on one particular branch from among the branches (4),
> - a calculating device (15, 18) able:
>
>> - to detect a change with regard to the electrical consumption in the installation (1) by communicating with at least one of the devices, namely the device (6) for carrying out measurements and the transducer (7, 8, 9), and
>> - to monitor an item of information in relation to an electric current (12, 13, 14) in the particular branch (4), originating from the transducer (7, 8, 9) fitted on this particular branch (4), and then
>> - by way of the item of information originating from the transducer (7, 8, 9) fitted on the particular branch (4), to establish an indication according to which said change has occurred on this particular branch (4), and then
>> - using both data from among the measurements (U, $I_A$, $\psi_A$) taken on the main upstream line before the change and data from among the measurements (U, $I_B$, $\psi_B$) taken on the main upstream line after the change, as well as said indication, to determine a particular individual consumption of energy in said particular branch (4),
>> said calculating device (15) being **characterized in that** it has several ways (30, 31, 32) of determining an individual consumption of energy in a branch and a table (18) for establishing at least one correspondence between at least one of the categories of the branches (4) and at least one of the ways (30, 31, 32), the calculating device (15, 18) being able to select one specific way (30, 31, 32) from among the ways of determining an individual consumption by combining said indication and the table (18), and to determine the particular individual consumption of energy by using the selected specific way (30, 31, 32) suitable for the category of the branch (4),

said supervision system (6, 7, 8, 9, 11, 12) being designed to perform over time and record measurements of an overall supply voltage (U) of the group of several branches (4), measurements of the magnitude and phase offset values (IA, IB, $\psi$A, $\psi$B) of an overall supply current (I) of the group of several branches (4), as well as measurements of the magnitude (I3A, I3B) of a specific individual current (13) flowing in one specific branch (4) of the group of branches, and **in that** the calculating device comprises a means for determining an individual power in the specific branch (4) by using a measurement of the overall voltage (U) that is substantially constant during the change, measurements of the magnitude and phase offset values (IA, IB, $\psi$A, $\psi$B) of the overall current (I) before and after the change, as well as measurements of the magnitudes (I3A, I3B) of the specific individual current (13) before and after the change.

**7.** Supervision system according to Claim 6, **characterized in that** the means for determining an individual power is designed to determine this individual power with consideration to the fact that all ($I_1$, $I_2$, $I_3$) of the individual currents flowing in the branches (4) of the group, with the exception of the specific individual current ($I_3$), add together to give a sum that is substantially unchanged at the end of the change, in comparison with before the change, and that two conditions have to be satisfied simultaneously, these being:

> - that the overall current (I) before the change has to be substantially equal to the addition of the substantially unchanged sum and the specific individual current ($I_3$) before the change, and

- that the overall current (I) after the change has to be substantially equal to the addition of the substantially unchanged sum and the specific individual current (I$_3$) after the change.

8. Supervision system according to Claim 7, **characterized in that** the calculating device comprises a means for eliminating one aberrant solution (S') out of two possible solutions (S, S').

9. Supervision system according to any one of Claims 6 to 8, **characterized in that** the calculating device comprises a means for determining an individual power in one of the branches (4) as being equal to the difference between an overall power in the group of branches (4) before the change and an overall power in the group of branches (4) after this change.

10. Supervision system according to any one of Claims 6 to 9, **characterized in that** the calculating device (8, 9, 11, 12) is able to execute a method according to any one of Claims 1 to 5.

11. Electrical installation, including a group of several branches (4) for individually distributing electricity between several loads (5a, 5b, 5c, 5d), a main upstream line (3) connecting the group of branches to an electric power supply (2), **characterized in that** it includes a supervision system (6, 7, 8, 9, 12) according to any one of Claims 6 to 10, the device (6) for carrying out measurements fitted on the main upstream line (3), one particular branch (4) from among the branches being equipped with the transducer (7, 8, 9).

**Fig. 1**

**Fig. 2**

**Fig. 3**

**Fig. 4**

Fig. 5

Fig. 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20100287489 A
- JP 2003070186 A
- WO 2010037988 A
- WO 2001177696 A
- EP 2000780 A
- EP 2026299 A
- WO 1010014762 A
- WO 2011002735 A
- WO A A
- US 5696695 A
- WO 2009158202 A